# EUROPÄISCHE PATENTSCHRIFT

(11) **EP 0 873 588 B1**
(45) Veröffentlichungstag und Bekanntmachung des Hinweises auf die Patenterteilung: **21.06.2000**
(21) Anmeldenummer: 96945151.7
(22) Anmeldetag: 02.10.1996
(51) Int. Cl.: H03C 3/09

(54) **VERFAHREN UND ANORDNUNG ZUR FREQUENZMODULATION EINES HOCHFREQUENTEN SIGNALS**
METHOD AND DEVICE FOR MODULATING THE FREQUENCY OF A HIGH-FREQUENCY SIGNAL
PROCEDE ET DISPOSITIF POUR LA MODULATION DE FREQUENCE D'UN SIGNAL HAUTE FREQUENCE

(30) Priorität: 13.01.1996 DE 19601013
(43) Veröffentlichungstag der Anmeldung: 28.10.1998
(73) Patentinhaber: ROBERT BOSCH GMBH, 70442 Stuttgart (DE)
(72) Erfinder: HAUK, Joachim, D-71665 Vaihingen (DE)
(86) Internationale Anmeldenummer: DE9601897
(87) Internationale Veröffentlichungsnummer: WO9725773

(56) Entgegenhaltungen:
- EP-A- 0 563 945
- WO-A-81/03250
- US-A- 4 119 925
- US-A- 4 151 485
- US-A- 4 223 261
- US-A- 4 468 638
- US-A- 4 929 918
- US-A- 5 168 245

## Beschreibung

Die Erfindung betrifft ein Verfahren und eine Anordnung zur Frequenzmodulation eines hochfrequenten Signals, wobei das hochfrequente Signal mit einem Oszillator erzeugt wird, der durch Vergleich eines Istfrequenzsignals mit einem veränderbaren Sollfrequenzsignal geregelt wird.

Ein solches Verfahren und die zugehörige Anordnung sind z.B. aus EP-A-0 563 945 bekannt.

In der Radartechnik, insbesondere bei Abstandssensoren, wird häufig eine zeitlineare Frequenzmodulation in Form von auf- und absteigenden Rampen benötigt. Dabei werden hohe Anforderungen an die Linearität und die Symmetrie der Rampen gestellt.

Aufgabe der vorliegenden Erfindung ist es, ein Verfahren und eine Anordnung zur Frequenzmodulation eines hochfrequenten Signals anzugeben, mit denen bei geringem Aufwand eine hohe Genauigkeit erzielt wird.

Diese Aufgabe wird durch die in den Unabhängigen Ansprüchen 1 (Verfahren) und 12 (Anordnung) definierte Erfindung gelöst.

Die Ableitung der Flanken des hochfrequenten Signals kann bei dem erfindungsgemäßen Verfahren in verschiedener Weise erfolgen. Bei sehr hohen Frequenzen, wie sie bei der bevorzugten Anwendung des erfindungsgemäßen Verfahrens auftreten, ist es vorteilhaft, wenn das hochfrequente Signal des Oszillators vor Gewinnung des Istfrequenzsignals mit einem Signal eines hochgenauen Referenz-Oszillators gemischt wird und das Istfrequenzsignal aus einem dabei entstehenden Mischprodukt gebildet wird. Vorzugsweise ist dabei vorgesehen, daß das vom Oszillator stammende oder abgeleitete Signal vor Bildung des Istfrequenzsignals einer Frequenzteilung unterworfen wird.

Das erfindungsgemäße Verfahren hat den Vorteil, daß die aufgabengemäß erzielte Genauigkeit durch digitale Schaltungen erzielt werden kann, so daß ein Abgleich weder bei der Herstellung noch später erforderlich ist. Ebenso wenig sind Maßnahmen zur Kompensation von Temperatur- und Alterungseffekten notwendig.

Das bei dem erfindungsgemäßen Verfahren entstehende Istfrequenzsignal enthält Impulse, deren Abstand untereinander entsprechend der zufälligen Phasenlage des Taktes und des aus dem hochfrequenten Signal gewonnenen Signals Schwankungen unterworfen ist. Im Mittel entsteht jedoch eine Frequenz, die der Frequenz des aus dem hochfrequenten Signal abgeleiteten Signals entspricht - also auch die Frequenz des hochfrequenten Signals repräsentiert.

Vorzugsweise wird bei dem erfindungsgemäßen Verfahren zur Ableitung der Steuerspannung einem Kondensator in Abhängigkeit vom Vorzeichen des Zählerstandes ein Strom in einer ersten oder zweiten, entgegengesetzten Richtung zugeführt.

Gemäß einer Weiterbildung des erfindungsgemäßen Verfahrens ist vorgesehen, daß zur Ableitung des Sollfrequenzsignals dem Inhalt eines Akkumulators im vorgegebenen Takt eine veränderbare Zahl hinzuaddiert wird und daß jeweils ein Impuls des Sollfrequenzsignals ausgegeben wird, wenn das höchstwertige Bit des Akkumulatorinhalts auf einen vorgegebenen Binärwert springt. Auch hierbei wird eine Impulsfolge generiert, bei der zwar die Impulse unterschiedliche Abstände aufweisen, die Frequenz jedoch im Mittel der Sollfrequenz entspricht.

Bei dieser Weiterbildung kann die Steigung der Rampen vorzugsweise dadurch bestimmt werden, daß die zu addierende veränderbare Zahl in einem weiteren Vorwärts-/Rückwärts-Zähler gespeichert und durch Dekrementieren und Inkrementieren des Zählers in Abhängigkeit von zugeführten Modulationssignalen verändert wird.

Zum Vorgeben einer Startfrequenz kann bei dem erfindungsgemäßen Verfahren der Vor-/Rückwärtszähler auf einen Startwert setzbar sein, welcher durch wiederholte Addition zum jeweiligen Akkumulatorinhalt ein Istfrequenzsignal entstehen läßt, das einem nicht frequenzmodulierten hochfrequenten Signal entspricht.

Bei der häufigsten Anwendung des erfindungsgemäßen Verfahrens, nämlich bei der Erzeugung von zeitlinearen Rampen, ist bei dem erfindungsgemäßen Verfahren vorgesehen, daß einem Vorwärts- und einem Rückwärtseingang des Vorwärts-/Rückwärts-Zählers je ein binäres Signal zuführbar ist, welches einen linearen Anstieg bzw. einen linearen Abfall der Frequenz bewirkt. Soll jedoch die Frequenzänderung nicht in zeitlinearer Weise erfolgen, so ist durchaus ein Dekrementieren und Inkrementieren mit einer vorgegebenen Zeitabhängigkeit möglich.

Für verschiedene Anwendungen ist eine Umschaltung der Steigung der Rampen erforderlich. Dazu kann bei dem erfindungsgemäßen Verfahren vorgesehen sein, daß die Steigung des linearen Anstiegs bzw. des linearen Abfalls dadurch verringert wird, daß die binären Signale während eines Teils der Taktperioden unterbrochen werden. Insbesondere kann die Steigung dadurch halbiert werden, daß nur während jeden zweiten Taktimpulses die binären Signale zugeführt werden.

Die erfindungsgemäße Aufgabe wird bei einer Anordnung zur Durchführung des Verfahrens dadurch gelöst, daß das aus dem hochfrequenten Signal abgeleitete Signal einem Flankendetektor zuführbar ist, daß ein Ausgang des Flankendetektors mit einem ersten Zähleingang eines Vorwärts-/Rückwärts-Zählers verbunden ist, daß ein Ausgang eines Generators, der Impulse mit einer mittleren Frequenz erzeugt, die der Sollfrequenz entspricht, an einen zweiten Zähleingang angeschlossen ist und daß der Vorwärts-/Rückwärts-Zähler mit Mitteln zur Ableitung einer Steuerspannung aus dem Zählerstand verbunden ist. Diese Anordnung enthält weitgehend digitale Schaltungen, die als integrierte Schaltkreise realisiert werden können.

Vorzugsweise ist bei der erfindungsgemäßen Anordnung vorgesehen, daß die Mittel zur Ableitung einer Steuerspannung zwei Stromquellen umfassen, die einem Kondensator in zueinander entgegengesetzter Richtung Strom zuführen und von denen jeweils eine oder, falls der Zählerstand "0" getrennt ausgewertet wird, zeitweilig auch keine in Abhängigkeit vom Vorzeichen des Fehlerstandes eingeschaltet wird.

Eine vorteilhafte Ausgestaltung der erfindungsgemäßen Anordnung besteht darin, daß der Generator einen Akkumulator enthält, zu dessen Inhalt im vorgegebenen Takt der Inhalt eines weiteren Vorwärts-/Rückwärts-Zählers hinzuaddiert wird und daß der weitere Vorwärts-/Rückwärts-Zähler im vorgegebenen Takt in Abhängigkeit von Modulationssignalen inkrementierbar oder dekrementierbar ist.

Ausführungsbeispiele der Erfindung sind in der Zeichnung anhand mehrerer Figuren dargestellt und in der nachfolgenden Beschreibung näher erläutert. Es zeigt:
- Fig. 1: ein Blockschaltbild einer erfindungsgemäßen Anordnung,
- Fig. 2: den Verlauf der Frequenz des hochfrequenten Signals bei einer rampenförmigen Modulation und den Verlauf zugehöriger Modulationssignale, die der Anordnung nach Fig. 4 zuführbar sind,
- Fig. 3: Zeitdiagramme zur Erläuterung der Ableitung des Istfrequenzsignals und
- Fig. 4: ein Blockschaltbild eines Generators zur Erzeugung des Sollfrequenzsignals.

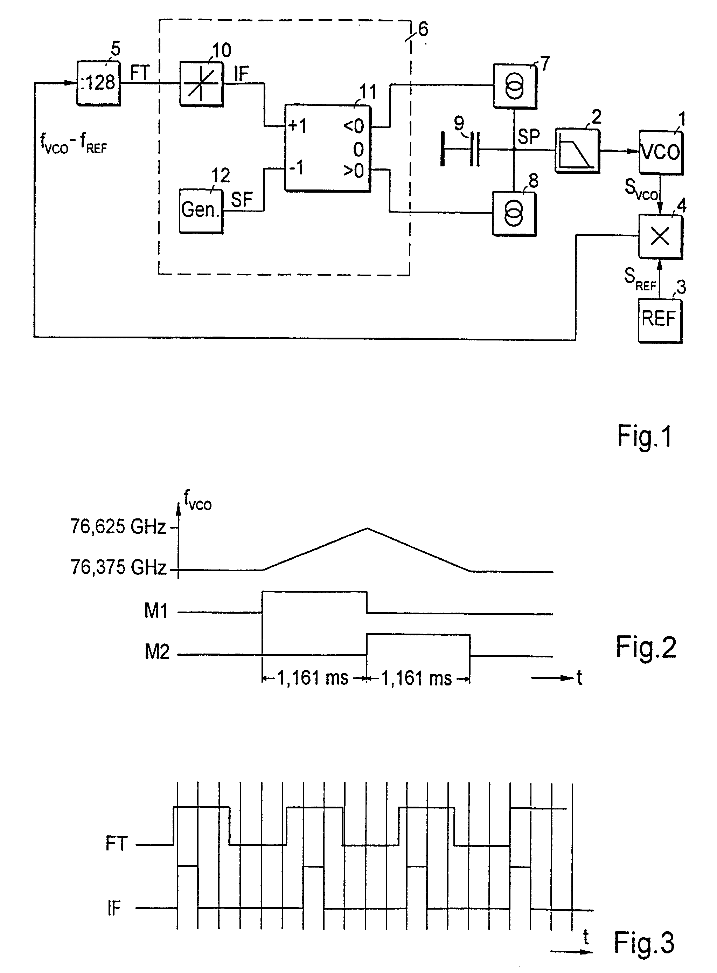

Bei der Anordnung nach Fig. 1 wird das hochfrequente Signal in einem steuerbaren Oszillator 1 erzeugt, dem zur Frequenzeinstellung über ein Tiefpaßfilter 2 eine Steuerspannung SP zugeführt wird. Für Abstandssensoren ist ein Frequenzbereich von 76 GHz bis 77 GHz freigegeben. Da Signale mit dieser Frequenz nicht ohne weiteres mit Schaltungsanordnungen, wie beispielsweise Frequenzteilern, verarbeitet werden können, erfolgt eine Mischung des hochfrequenten Signals S_{VCO} mit einem Signal S_{REF} eines hochgenauen Referenz-Oszillators 3. Das Mischprodukt |f_{VCO}-f_{REF}| wird einem Frequenzteiler 5 zugeleitet, der im Falle des Ausführungsbeispiels die Frequenz durch 128 teilt. Das Ausgangssignal FT des Frequenzteilers 5 ist ein Rechtecksignal mit einer Frequenz im Bereich von 2,625 MHz bis 4,578 MHz.

Die Frequenz f_{VCO} soll nun entsprechend Fig. 2 moduliert werden, d.h., von einer Ruhefrequenz von z.B. 76,375 GHz soll die Frequenz linear innerhalb von 1,161 ms um 250 MHz ansteigen und darauf wiederum in 1,161 ms auf 76,375 GHz abfallen. Der Anstieg und der Abfall sollen während jeweils eines der Modulationssignale M1 oder M2 erfolgen.

Zur Erzeugung dieses Verlaufs wird die dem steuerbaren Oszillator 1 über das Tiefpaßfilter 2 zugeführte Steuerspannung SP mit Hilfe eines synchronen Schaltwerks 6 zweier Stromquellen 7, 8 und eines Kondensators 9 gebildet. Das synchrone Schaltwerk 6 besteht aus einem Flankendetektor 10, einem Vorwärts-/Rückwärts-Zähler 11 und einem Generator 12 für das Sollfrequenzsignal.

Der Flankendetektor 10 bewirkt, daß nach jeder positiven Flanke des Ausgangssignals des Frequenzteilers 5 für die Dauer einer Periode eines zugeführten Takts CL eine "1" ausgegeben wird. Dieser Vorgang ist in Fig. 3 anhand von Zeitdiagrammen der Signale FT und IF dargestellt, wobei die senkrechten Linien den Takt CL darstellen und das dargestellte Frequenzverhältnis willkürlich gewählt ist. Die Flanken des Signals FT entsprechen den Nulldurchgängen eines Sinussignals oder eines zwischen positiven und negativen Werten wechselnden Rechtecksignals. Da die Flanken des Signals FT nicht mit dem Takt CL synchronisiert sind und ferner die Taktfrequenz nicht wesentlich größer als die Frequenz des Signals FT ist, weisen die Impulse des Istfrequenzsignals IF untereinander verschiedene Abstände auf, wobei jedoch die mittlere Frequenz der Frequenz des Signals FT entspricht, die im folgenden als Istfrequenz bezeichnet wird, obwohl sie sich von der Istfrequenz des hochfrequenten Signals unterscheidet.

Ein Generator 12 erzeugt Impulse, deren mittlere Frequenz dem Sollwert der Frequenz des Signals FT entspricht. Die Signale IF uns SF werden je einem Eingang des Vorwärts-/Rückwärts-Zählers 11 zugeleitet, wobei jeweils ein Impuls des Signals IF eine Inkrementierung und ein Impuls des Signals SF eine Dekrementierung des Zählerstandes bewirkt. Treffen zwei Impulse gleichzeitig ein, behält der Zählerstand seinen Wert.

Ist die Istfrequenz kleiner als die Sollfrequenz, so treffen Impulse des Signals SF häufiger ein als diejenigen des Signals IF. Der Zählerstand wird dann negativ. Ein den negativen Zählerstand anzeigendes Signal wird einer Stromquelle 7 zugeführt, welche den Kondensator 9 in einer frequenzerhöhenden Richtung lädt. Ist jedoch die Istfrequenz größer als die Sollfrequenz, wird der Zählerstand positiv und die Stromquelle 8 angesteuert, die frequenzvermindernd wirkt.

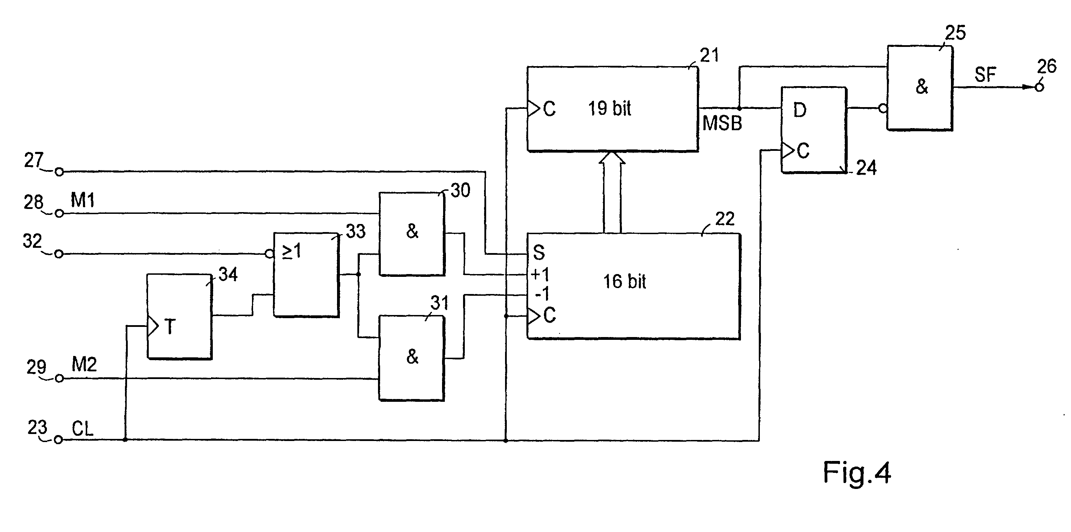

Fig. 4 zeigt ein Ausführungsbeispiel für einen Generator 12 (Fig. 1). Ein Akkumulator 21 mit einer Kapazität von 19 Bit wird zusammen mit einem Vorwärts-/Rückwärts-Zähler 22 mit einem bei 23 zugeführten Takt CL getaktet. Mit jedem Takt wird der Inhalt des Akkumulators 21 um den jeweiligen Zählerstand erhöht. Dem Akkumulator wird das höchstwertige Bit (MSB) entnommen. Mit Hilfe eines D-Flip-Flops 24, das ebenfalls mit CL getaktet wird, und einer Und-Schaltung 25 entsteht nach jedem Sprung des MSB von "0" auf "1" ein Impuls, dessen Breite der Periodendauer des Taktes CL entspricht. Diese Impulse werden als Signal SF dem Vorwärts-/Rückwärts-Zähler 11 (Fig. 1) zugeleitet.

Einem Eingang 27 wird ein Anfangswert für den Vorwärts-/Rückwärts-Zähler 22 zugeleitet. Dieser Wert ist beispielsweise B000(hex), was eine Startfrequenz von 336 MHz bedeutet. Bei einer Taktfrequenz von 21 MHz entfallen auf eine Rampe von 1,161 ms 24381 Takte. Der Frequenzhub beträgt 250 MHz, wenn bei jedem Takt der Vorwärts-/Rückwärts-Zähler 22 um "1" inkrementiert oder dekrementiert wird. Dazu werden Eingängen 28, 29 die in Fig. 3 dargestellten Modulationssignale M1 und M2 zugeleitet. Die Und-Schaltungen 30, 31 sind in diesem Fall für die Signale M1 und M2 ständig durchlässig.

Zur Verringerung der Steigung der Rampen wird über einen Eingang 32 einem invertierenden Eingang einer Oder-Schaltung 33 eine "1" zugeleitet. Der andere Eingang der Oder-Schaltung 33 ist mit dem Ausgangssignal eines Zweiteilers 34 belegt, der mit dem Takt CL getaktet wird. Die Oder-Schaltung 33 leitet dann abwechselnd eine "1" oder eine "0" an die Und-Schaltungen 30, 31 weiter, so daß während jeden zweiten Takts eine Inkrementierung bzw. Dekrementierung des Vorwärts-/Rückwärts-Zähler 22 unterbleibt.

Zur Erzielung einer Rampe mit der vollen Steigung wird dem Eingang 32 eine "0" zugeleitet, die in der Oder-Schaltung 33 als "1" unabhängig vom Pegel am anderen Eingang zu den Und-Schaltungen 30, 31 weitergeleitet wird, so daß die Signale M1 und M2 nicht unterbrochen werden.

## Patentansprüche

1. Verfahren zur Frequenzmodulation eines hochfrequenten Signals,
- wobei das hochfrequente Signal mit einem Oszillator (1) erzeugt wird,
- der durch Vergleich eines Istfrequenzsignals (IF) mit einem veränderbaren Sollfrequenzsignal (SF) geregelt wird,
- wobei Impulse einen Vorwärts-/Rückwärts-Zähler (11) dekrementieren oder inkrementieren,
- aus dessen Zählerstand eine Steuerspannung (SP) für den Oszillator (1) abgeleitet wird,
dadurch gekennzeichnet,
- daß das Istfrequenzsignal aus ersten Impulsen mit einer mittleren Wiederholfrequenz besteht, die einer Istfrequenz entspricht,
- daß das Sollfrequenzsignal aus zweiten Impulsen mit einer mittleren Wiederholfrequenz besteht, die einer Sollfrequenz entspricht und
- daß die Impulse des Istfrequenzsignals den Vorwärts-/Rückwärts-Zähler in einer ersten Zählrichtung und die Impulse des Sollfrequenzsignals den Vorwärts-/Rückwärts-Zähler in einer entgegengesetzten zweiten Zählrichtung inkrementieren oder dekrementieren.

2. Verfahren nach Anspruch 1, dadurch gekennzeichnet,
- daß die Impulse des Istfrequenzsignals aus Flanken des hochfrequenten Signals abgeleitet sind
- daß die Impulse des Istfrequenzsignals in ihrer Phasenlage von einem vorgegebenen Takt festgelegt sind.

3. Verfahren nach Anspruch 1 oder 2, dadurch gekennzeichnet, daß das hochfrequente Signal des Oszillators vor Gewinnung des Istfrequenzsignal mit dem Signal eines hochgenauen Referenz-Oszillators gemischt wird und das Istfrequenzsignal aus einem dabei entstehenden Mischprodukt gebildet wird.

4. Verfahren nach einem der Ansprüche 1 bis 3, dadurch gekennzeichnet, daß das vom Oszillator stammende oder abgeleitete Signal vor Bildung des Istfrequenzsignals einer Frequenzteilung unterworfen wird.

5. Verfahren nach einem der vorhergehenden Ansprüche, dadurch gekennzeichnet, daß zur Ableitung der Steuerspannung (SP) einem Kondensator (9) in Abhängigkeit vom Vorzeichen des Zählerstandes (11) ein Strom in einer ersten oder zweiten, entgegengesetzten Richtung zugeführt wird.

6. Verfahren nach einem der vorhergehenden Ansprüche, dadurch gekennzeichnet, daß zur Ableitung des Sollfrequenzsignals dem Inhalt eines Akkumulators (21) im vorgegebenen Takt eine veränderbare Zahl hinzuaddiert wird und daß jeweils ein Impuls des Sollfrequenzsignals ausgegeben wird, wenn das höchstwertige Bit des Akkumulatorinhalts auf einen vorgegebenen Binärwert springt.

7. Verfahren nach Anspruch 6, dadurch gekennzeichnet, daß die zu addierende veränderbare Zahl in einem weiteren Vorwärts-/Rückwärts-Zähler (22) gespeichert und durch Dekrementieren und Inkrementieren des Zählers in Abhängigkeit von zugeführten Modulationssignalen verändert wird.

8. Verfahren nach Anspruch 7, dadurch gekennzeichnet, daß der Vor/Rückwärtszähler (22) auf einen Startwert setzbar ist, welcher durch wiederholte Addition zum jeweiligen Akkumulatorinhalt ein Istfrequenzsignal entstehen läßt, daß einem nicht frequenzmodulierten Signal entspricht.

9. Verfahren nach einem der Ansprüche 7 oder 8, dadurch gekennzeichnet, daß einem Vorwärts- und einem Rückwärtseingang des Vorwärts-/Rückwärts-Zählers (22) je ein binäres Signal zuführbar ist, welches einen linearen Anstieg bzw. einen linearen Abfall der Frequenz bewirkt.

10. Verfahren nach Anspruch 9, dadurch gekennzeichnet, daß die Steigung des linearen Anstiegs bzw. des linearen Abfalls dadurch verringert wird, daß die binären Signale während eines Teils der Taktperioden unterbrochen werden.

11. Verfahren nach Anspruch 10, dadurch gekennzeichnet, daß die Steigung dadurch halbiert wird, daß nur während jeden zweiten Taktimpulses die binären Signale zugeführt werden.

12. Anordnung zur Durchführung des Verfahrens nach Anspruch 1,
- mit einem Oszillator (1) zur Erzeugung eines hochfrequenten Signals,
- mit Mitteln (3,4,5,10) zur Ableitung eines Istfrequenzsignals aus dem hochfrequenten Signal,
- mit einem Generator (12) zur Erzeugung eines veränderbaren Sollfrequenzsignals,
- mit einem Vorwärts-/Rückwärts-Zähler (11), der mit Mitteln (7,8,9) zur Ableitung einer Steuerspannung für den Oszillator aus dem Zählerstand verbunden ist,
dadurch gekennzeichnet,
- daß das Istfrequenzsignal aus ersten Impulsen mit einer mittleren Wiederholfrequenz besteht, die einer Istfrequenz entspricht und einem ersten Zähleingang des Vorwärts-/Rückwärts-Zählers (11) zugeführt ist,
- daß das Sollfrequenzsignal aus zweiten Impulsen mit einer mittleren Wiederholfrequenz besteht, die einer Sollfrequenz entspricht und einem zweiten Zähleingang des Vorwärts-/Rückwärts-Zählers (11) zugeführt ist,
- wobei Impulse am ersten und am zweiten Zähleingang den Vorwärts-/Rückwärts-Zähler (11) in zueinander entgegengesetzte Zählrichtungen inkrementieren oder dekrementieren.

13. Anordnung nach Anspruch 12, dadurch gekennzeichnet, daß die Mittel zur Ableitung einer Steuerspannung zwei Stromquellen (7,8) umfassen, mit denen einem Kondensator (9) in zueinander entgegengesetzter Richtung Strom zuführbar ist und von denen jeweils eine in Abhängigkeit vom Vorzeichen des Zählerstandes eingeschaltet ist.

14. Anordnung nach einem der Ansprüche 12 oder 13, dadurch gekennzeichnet, daß der Generator (12) einen Akkumulator (21) enthält, zu dessen Inhalt im vorgegebenen Takt der Inhalt eines weiteren Vorwärts-/Rückwärts-Zählers (22) hinzuaddiert wird und daß der weitere Vorwärts-/Rückwärts-Zähler (22) im vorgegebenen Takt in Abhängigkeit von Modulationssignalen inkrementierbar oder dekrementierbar ist.

## Claims

1. Method of frequency-modulating a high-frequency signal,
- in which the high-frequency signal is produced using an oscillator (1),
- which is regulated by comparing an actual frequency signal (IF) with a variable nominal frequency signal (SF),
- in which pulses decrement or increment an up/down counter (11),
- whose counter reading is used to derive a control voltage (SP) for the oscillator (1),
characterized
- in that the actual frequency signal comprises first pulses having a mean repetition rate which corresponds to an actual frequency,
- in that the nominal frequency signal comprises second pulses having a mean repetition rate which corresponds to a nominal frequency, and
- in that the pulses of the actual frequency signal increment or decrement the up/down counter in a first counting direction, and the pulses of the nominal frequency signal increment or decrement the up/down counter in an opposite second counting direction.

2. Method according to Claim 1, characterized
- in that the pulses of the actual frequency signal are derived from edges of the high-frequency signal,
- in that the phase angle of the pulses of the actual frequency signal are defined by a predetermined clock signal.

3. Method according to Claim 1 or 2, characterized in that the high-frequency signal of the oscillator is mixed with the signal of a high-precision reference oscillator before the actual frequency signal is obtained, and the actual frequency signal is formed from a mixed product which is then produced.

4. Method according to one of Claims 1 to 3, characterized in that the signal originating or derived from the oscillator is subjected to frequency division before the actual frequency signal is formed.

5. Method according to one of the preceding claims, characterized in that, to derive the control voltage (SP), a current is supplied to a capacitor (9) in a first or second, opposite direction, depending on the sign of the counter reading (11).

6. Method according to one of the preceding claims, characterized in that, to derive the nominal frequency signal, a variable number is added to the content of an accumulator (21) at the predetermined clock rate, and in that a respective pulse of the nominal frequency signal is output when the most significant bit of the accumulator content jumps to a predetermined binary value.

7. Method according to Claim 6, characterized in that the variable number to be added is stored in a further up/down counter (22) and is varied by decrementing and incrementing the counter as a function of supplied modulation signals.

8. Method according to Claim 7, characterized in that the up/down counter (22) can be set to a start value which, through repeated addition to the respective accumulator content, produces an actual frequency signal which corresponds to a signal which has not been frequency-modulated.

9. Method according to one of Claims 7 and 8, characterized in that a respective binary signal can be supplied to an up and a down input of the up/down counter (22), said binary signal causing a linear rise or a linear fall in the frequency.

10. Method according to Claim 9, characterized in that the gradient of the linear rise or of the linear fall is reduced by the binary signals being interrupted during some of the clock periods.

11. Method according to Claim 10, characterized in that the gradient is halved by the binary signals being supplied only during every second clock pulse.

12. Arrangement for carrying out the method according to Claim 1,
- having an oscillator (1) for producing a high-frequency signal,
- having means (3, 4, 5, 10) for deriving an actual frequency signal from the high-frequency signal,
- having a generator (12) for producing a variable nominal frequency signal,
- having an up/down counter (11) which is connected to means (7, 8, 9) for deriving a control voltage for the oscillator from the counter reading,
characterized
- in that the actual frequency signal comprises first pulses having a mean repetition rate which corresponds to an actual frequency and is supplied to a first count input of the up/down counter (11),
- in that the nominal frequency signal comprises second pulses having a mean repetition rate which corresponds to a nominal frequency and is supplied to a second count input of the up/down counter (11),
- pulses at the first and at the second count input incrementing or decrementing the up/down counter (11) in mutually opposite counting directions.

13. Arrangement according to Claim 12, characterized in that the means for deriving a control voltage comprise two current sources (7, 8) which can be used to supply current to a capacitor (9) in mutually opposite directions and one of which, respectively, is switched on depending on the sign of the counter reading.

14. Arrangement according to one of Claims 12 and 13, characterized in that the generator (12) contains an accumulator (21) whose content has the content of a further up/down counter (22) added to it at the predetermined clock rate, and in that the further up/down counter (22) can be incremented or decremented at the predetermined clock rate as a function of modulation signals.

## Revendications

1. Procédé de modulation de fréquence d'un signal haute fréquence, où le signal haute fréquence est généré à l'aide d'un oscillateur 1 qui est régulé par comparaison entre un signal de fréquence réelle (IF) et un signal de fréquence de consigne (SF) modifiable, où des impulsions décrémentent ou incrémentent un compteur ascendant/descendant (11), une tension de commande (SP) destinée à l'oscillateur (1) étant dérivée de son état de comptage,
caractérisé en ce que
• le signal de fréquence réelle est constitué de premières impulsions, ayant une fréquence répétitive moyenne, correspondant à une fréquence réelle,
• le signal de fréquence de consigne est constitué de deuxièmes impulsions, ayant une fréquence répétitive moyenne correspondant à une fréquence de consigne, et
• les impulsions du signal de fréquence réelle incrémentent ou décrémentent le compteur ascendant/descendant dans une première direction de comptage et les impulsions du signal de fréquence de consigne incrémentent ou décrémentent le compteur ascendant/descendant dans une deuxième direction de comptage, opposée.

2. Procédé selon la revendication 1,
caractérisé en ce que
• les impulsions du signal de fréquence réelle sont dérivées des flancs du signal haute fréquence,
• les impulsions du signal de fréquence réelle ont leur position de phase fixée par une cadence prédéterminée.

3. Procédé selon la revendication 1 ou 2,
caractérisé en ce que
le signal haute fréquence de l'oscillateur, avant obtention du signal de fréquence réelle, est mélangé au signal d'un oscillateur de référence de haute précision et le signal de fréquence réelle est constitué d'un produit mélangé alors constitué.

4. Procédé selon l'une des revendications 1 à 3,
caractérisé en ce que
le signal provenant ou dérivé de l'oscillateur est soumis à une division de fréquence avant la formation du signal de fréquence réelle.

5. Procédé selon une ou plusieurs des revendications précédentes,
caractérisé en ce qu'
un courant orienté dans une première ou une deuxième direction opposée est amené à un condensateur (9) en fonction du signe de l'état de comptage (11), en vue de dériver la tension de commande (SP).

6. Procédé selon une ou plusieurs des revendications précédentes,
caractérisé en ce que
• pour dériver le signal de fréquence de consigne, on ajoute au contenu d'un accumulateur (21), suivant une cadence prédéterminée, un nombre modifiable, et,
• on produit alors chaque fois une impulsion du signal de fréquence de consigne lorsque le bit de valeur maximale du contenu de l'accumulateur passe à une valeur binaire prédéterminée.

7. Procédé selon la revendication 6,
caractérisé en ce que
le nombre modifiable à ajouter est mémorisé dans un deuxième compteur ascendant/descendant (22) et est modifié par décrémentation et incrémentation du compteur, en fonction des signaux de modulation amenés.

8. Procédé selon la revendication 7,
caractérisé en ce que
le compteur ascendant/descendant (22) est susceptible d'être placé à une valeur initiale qui, par addition répétée au contenu respectif de l'accumulateur, donne un signal de fréquence réelle qui correspond à un signal non modulé en fréquence.

9. Procédé selon l'une des revendications 7 ou 8,
caractérisé en ce qu'
à une entrée ascendante et à une entrée descendante du compteur ascendant/descendant (22) est susceptible d'être amené respectivement un signal binaire, provoquant une augmentation linéaire ou une diminution linéaire de la fréquence.

10. Procédé selon la revendication 9,
caractérisé en ce que
la pente de la montée linéaire ou de la descente linéaire est diminuée par le fait que les signaux binaires sont interrompus pendant une partie des périodes de cadencement.

11. Procédé selon la revendication 10,
caractérisé en ce que
la pente est divisée par deux, par le fait qu'on amène les signaux binaires uniquement pendant chaque deuxième impulsion de cadencement.

12. Dispositif de mise en oeuvre du procédé selon la revendication 1,
• avec un oscillateur (1) pour générer un signal haute fréquence,
• avec des moyens (3, 4, 5, 10) pour dériver un signal de fréquence réelle à partir du signal haute fréquence,
• avec un générateur (12) pour produire un signal de valeur de consigne modifiable,
• avec un compteur ascendant/descendant (11), relié à des moyens (7, 8, 9) pour dériver, à partir de l'état de comptage, une tension de commande destinée à l'oscillateur,
caractérisé en ce que
• le signal de fréquence réelle est constitué de premières impulsions à une fréquence répétitive moyenne qui correspond à une fréquence réelle, et est amené à une première entrée de comptage du compteur ascendant/descendant (11),
• le signal de fréquence de consigne est constitué de deuxièmes impulsions ayant une fréquence répétitive moyenne, correspondant à une fréquence de consigne, et est amené à une deuxième entrée de comptage du compteur ascendant/descendant (11),
• les impulsions, appliquées à la première et à la deuxième entrées de comptage, incrémentant ou décrémentant le compteur ascendant/descendant (11), dans des directions de comptage mutuellement opposées.

13. Dispositif selon la revendication 12,
caractérisé en ce que
les moyens pour dériver une tension de commande comprennent deux sources de courant (7, 8), à l'aide desquelles un courant peut être amené dans une direction mutuellement opposée à un condensateur (9), et dont l'une est chaque fois mise en service, en fonction du signe de l'état de comptage.

14. Dispositif selon l'une des revendications 12 ou 13,
caractérisé en ce que
le générateur (12) contient un accumulateur (21), au contenu duquel selon une cadence prédéterminée, on ajoute le contenu d'un autre compteur ascendant/descendant (22), et en ce que l'autre compteur ascendant/descendant (22) est susceptible d'être incrémenté ou décrémenté selon une cadence prédéterminée, en fonction de signaux de modulation.
